# FASCICULE DE BREVET EUROPEEN

(11) **EP 0 421 847 B1**
(45) Date de publication et mention de la délivrance du brevet: **30.03.1994**
(21) Numéro de dépôt: 90402673.9
(22) Date de dépôt: 27.09.1990
(51) Int. Cl.: H05K 7/14, G11B 33/12

(54) **Dispositif de fixation de périphériques d'ordinateur**
Befestigungsvorrichtung für Computerperipherien
Fastening device for computer peripheral units

(30) Priorité: 05.10.1989 FR 8913034
(43) Date de publication de la demande: 10.04.1991
(73) Titulaire: BULL S.A., 92800 Puteaux (FR)
(72) Inventeur: Remise, René, F-91940 Les Ulis (FR); Odo, Pierre, F-91940 Les Ulis (FR)
(74) Mandataire: Debay, Yves

(56) Documents cités:
- US-A- 4 725 244
- IBM TECHNICAL DISCLOSURE BULLETIN, vol. 30, no. 1, juin 1987, NEW YORK US pages 392 - 393; "DIRECT-ACCESS STORAGE DEVICE COMMODITY-STACKING PLATES"
- IBM TECHNICAL DISCLOSURE BULLETIN, vol. 29, no. 12, mai 1987, NEW YORK US pages 5292 - 5293; "GROUNDED FILE-MOUNTING PLATE"
- IBM TECHNICAL DISCLOSURE BULLETIN, vol. 30, no. 2, juillet 1987, NEW YORK US pages 882 - 887; "DIRECT ACCESS STORAGE DEVICE COMMODITY ASSEMBLY INTEGRATION INTO THE IBM PERSONAL COMPUTER XT ENVELOPE"
- IBM TECHNICAL DISCLOSURE BULLETIN, vol. 31, no. 6, novembre 1988, NEW YORK US pages 410 - 414; "DIRECT ACCESS STORAGE DEVICE FRAME ASSEMBLY AND FRAME-MOUNTING DEVICE"
- IBM TECHNICAL DISCLOSURE BULLETIN, vol. 27, no. 8, janvier 1985, NEW YORK US pages 5022 - 5023; G. Escobar and J.H. Neer: "DRIVE SPRING LOCK"
- RESEARCH DISCLOSURE, no. 283, novembre 1987, HAVANT GB -28328: "FLEXIBLE PLASTIC SNAP-IN RETAINERS FOR DATA STORAGE DEVICE"

## Description

La présente invention concerne un dispositif de fixation de périphériques d'ordinateur.

Il est connu, notamment dans le domaine des micro-ordinateurs, d'utiliser des dispositifs de fixation des périphériques d'ordinateur. Un tel dispositif est enseigné par le brevet US 4 725 244 dans lequel un périphérique est monté sur un plateau qui est engagé par coulissement sur le châssis du micro-ordinateur. Un tel assemblage nécessite la fixation du périphérique sur le plateau au moyen de vis.

Le premier but de l'invention est, par conséquent, de permettre un montage rapide et automatisable d'un périphérique constituant la configuration de base d'un micro-ordinateur, tel qu'un lecteur de disquettes.

Ce but est atteint par le fait que le dispositif de fixation pour périphérique d'ordinateur, comprenant une pièce support (1), montée solidaire de façon amovible à un châssis (90, 91, 92) d'un micro-ordinateur, la pièce support comprenant une première (10) une seconde (12) et une troisième surface (11), les dites seconde et troisième surfaces (12,11) étant d'une part mutuellement parallèles et d'autre part perpendiculaires à la première surface (10) formant ainsi une pièce en U avec des jambes orientées vers le bas, ladite première surface (10) comprenant des premiers moyens de fixation pour fixer un premier périphérique (3) à ladite pièce support sur un côté de ladite première surface (10) opposé aux jambes s'étendant vers le bas, et dans lequel un premier jeu d'ergots (103) est disposé sur ladite première surface (10) et une lame élastique (7) est disposée perpendiculairement à ladite première surface (10) et parallèle au dit premier jeu d'ergots (103), ladite lame étant fixée à une des dites seconde (12) et troisième (11) surfaces perpendiculaires à la première surface (10), ladite lame élastique (7) ayant un second jeu d'ergots (73) formé dans cette lame, ledit second jeu d'ergots (73) est espacé du premier jeu d'ergots (103) d'une distance correspondant à l'espacement des trous de fixation du boîtier du premier périphérique (3) et dans lequel chaque ergot du second jeu pénètre une ouverture de fixation correspondante quand le dit périphérique est monté sur le dispositif.

Selon une autre particularité, la lame élastique (7) est fixée de façon amovible sur la seconde surface (12), la seconde surface étant perpendiculaire à, et intégrée à ladite première surface (10) et disposée dans une direction opposée au premier jeu d'ergots (103), la lame (7) ayant deux découpes (710A, 710B) et deux ouvertures (7110, 7130) ladite seconde surface ayant deux languettes (121A, 121B) et deux bossages (125A, 125B) formés par emboutissage et déformation de ladite seconde surface (12), les découpes (710A,710B) étant adaptées pour être placées sous les deux langues (121A, 121B) de la seconde surface (12), les bossages (125A, 125B) étant disposés pour se clipser dans les ouvertures correspondantes (7110, 7130) de la lame élastique.

Un but supplémentaire est de permettre un montage rapide et automatisable des périphériques permettant de constituer la configuration de base d'un micro-ordinateur en particulier sur un support qui permette le montage d'au moins deux périphériques dont le deuxième peut être un dérouleur ultra rapide de bandes magnétique en cartouche (streamer) ou unité de lecteur de disquettes ou un disque dur.

Ce but est atteint par le fait que ladite pièce support (1) est adaptée pour recevoir un second moyen pour monter de façon amovible un second périphérique (4) ledit second moyen de fixation étant monté entre les jambes de la pièce support (1) en forme de U.

Un but supplementaire est de permettre le montage de périphériques fragiles.

Ce but est atteint par le fait que le second moyen de fixation pour monter un second périphérique (4), comprend une paire de découpes (102A, 102B, 110A, 110B) embouties disposées dans chacune des seconde (12) et troisième (11) surfaces, chacune des découpes comprenant une portion de découpe verticale et une portion inclinée en rampe s'étendant latéralement, ladite portion de rampe inclinée se terminant avec un point de blocage (1201) pour accueillir des passe-fils (41A,41B,41C,41D) en matériau élastique et amortisseur montés sur des vis (40A,40B,40C,40D) de fixation visées sur les trous de fixation (42A,42B,42C,42D) d'un boîtier du second périphérique (4).

Un but supplémentaire de l'invention est de permettre le montage d'un boîtier de périphérique au format par exemple de 3½ pouces, inférieur au format constitué par la distance séparant les jambes de la pièce support et correspondant substantiellement au format 5¼ pouces.

Ce but est atteint par le fait que les seconds moyens de fixation pour fixer un second périphérique (4) comprennent par un étrier en U (50, 51, 52) ayant une surface (50) qui est disposée horizontalement quand les dits seconds moyens de fixation sont montés sur la pièce support (1) et ayant deux jambes orientées verticalement vers le haut, ledit étrier étant monté de façon amovible à l'aide d'un assemblage à charnières (520, 123) et suspendu à la première surface (10) par une languette élastique (510, 511) adjacente à la première jambe comportant une languette d'accrochage (512) destinée, après être passée à travers une ouverture (104) de la première surface (10), à appuyer contre la face supérieure de la première surface (10), la première jambe (51) du U venant en appui contre la face inférieure de ladite première surface (10) à proximité de la languette d'accrochage (512).

Selon une autre particularité l'articulation charnière (123, 520), est intégrée à la seconde jambe (52) du U, et comporte des moyens pour positionner la surface horizontale (50) de l'étrier une fois que la langue (512) est verrouillée, les moyens étant constitués par un rebord plié (521) venant appuyer sur la partie supérieure d'une découpe (122) prévue à cet effet dans la deuxième surface (12), tandis que les languettes (520A, 520B) formant l'articulation appuient sur la partie inférieure des découpes (123A, 123B) prévues dans la deuxième surface (12).

Un but supplementaire de l'invention est de permettre le montage d'un périphérique supplémentaire, tel qu'un disque dur, ne nécessitant pas un accès de l'extérieur du boîtier du micro-ordinateur en cours de fonctionnement, mais permettant, lorsque le boîtier est ouvert, un accès facile à des éléments disposés en dessous de ce périphérique sur la carte électronique principal de la machine.

Ce but est atteint par le fait que le dispositif comprend des troisièmes moyens pour monter un troisième périphérique et ledit dispositif comportant une ouverture (102) prévue dans la première surface (10), à l'arrière des premiers moyens pour le premier périphérique (3), l'ouverture (102) étant destinée à recevoir lesdits troisièmes moyens (8) de fixation du périphérique (2) montés selon une direction perpendiculaire à la direction du premier périphérique (3), les dits troisièmes moyens (8) permettant de basculer temporairement le périphérique pour accéder à un connecteur (60) situé sur une carte (6) de circuit imprimé sur laquelle est montée la pièce de support (1).

Un but supplementaire est de permettre le montage de trois périphériques.

Ce but est atteint par le fait que le troisième moyen de fixation (8) comprend un étrier en forme de U (80, 81, 82) ayant deux jambes latérales (81,82) et une portion centrale (80), dont les jambes (81, 82) se prolongent en avant et en arrière de la partie centrale du U par des bras (812, 811, 821, 822), et disposée en vis à vis d'une première paire de bras (812, 822) des moyens (1020A,1020B) permettant l'articulation sur les côtés de l'ouverture (102), une seconde paire de bras (811, 821) comportant des moyens (8211, 8111) d'encliquetage sur les surfaces (1020C, 1020D) de l'ouverture prévue à cet effet pour constituer la position d'utilisation du périphérique (2), tandis que l'élasticité de cette seconde paire de bras (811, 821) permet leur dégagement par désencliquetage pour autoriser le basculement.

Un dernier but de l'invention est de proposer une utilisation du dispositif de fixation de périphériques d'ordinateurs.

Ce but est atteint parle fait que le dispositif de fixation est monté dans un châssis d'ordinateur ayant un panneau de fond, une plaque avant (90) et une plaque arrière (91) par coulissement entre des rainures constituées par des bossages (900, 910) réalisés sur les plaques avant (90) et arrière (91) du châssis et solidarisé aux plaques et à une carte de circuit imprimé (6) reposant sur le fond (92) du châssis de l'ordinateur par des moyens de fixation démontables (111, 110, 124).

D'autres caractéristiques et avantages de la présente invention apparaîtront plus clairement à la lecture de la description ci-après, faite en référence des dessins annexés, dans lesquels :
- la figure 1 représente une vue en perspective du dispositif de fixation associé à un deuxième moyen de fixation selon l'invention ;
- la figure 2 représente une vue en perspective d'une pièce support, montée dans le châssis d'une machine;
- la figure 3 représente une vue en perspective du dispositif de fixation avec une variante de réalisation d'un deuxième moyen de fixation ;
- la figure 4 représente une vue latérale de la pièce support ;
- la figure 5 représente une vue du dessus de la même pièce support ;
- la figure 6 représente une vue de devant de la pièce support associée avec une carte de circuit imprimé et un deuxième moyen de fixation d'un périphérique ;
- la figure 7 représente une vue latérale du clip de maintient d'un lecteur de disquette ;
- la figure 8 représente une vue en coupe du clip de maintient d'un lecteur de disquette ;
- la figure 9 représente une vue de dessus de l'étrier à bras basculant, constituant un troisième moyen de fixation ;
- la figure 10 représente une vue en coupe et de devant du même dispositif ;
- la figure 11 représente une vue latérale du deuxième moyen de fixation de périphérique de dimension inférieure à la pièce support ;
- la figure 12 représente une vue du dessus de ce moyen de fixation.

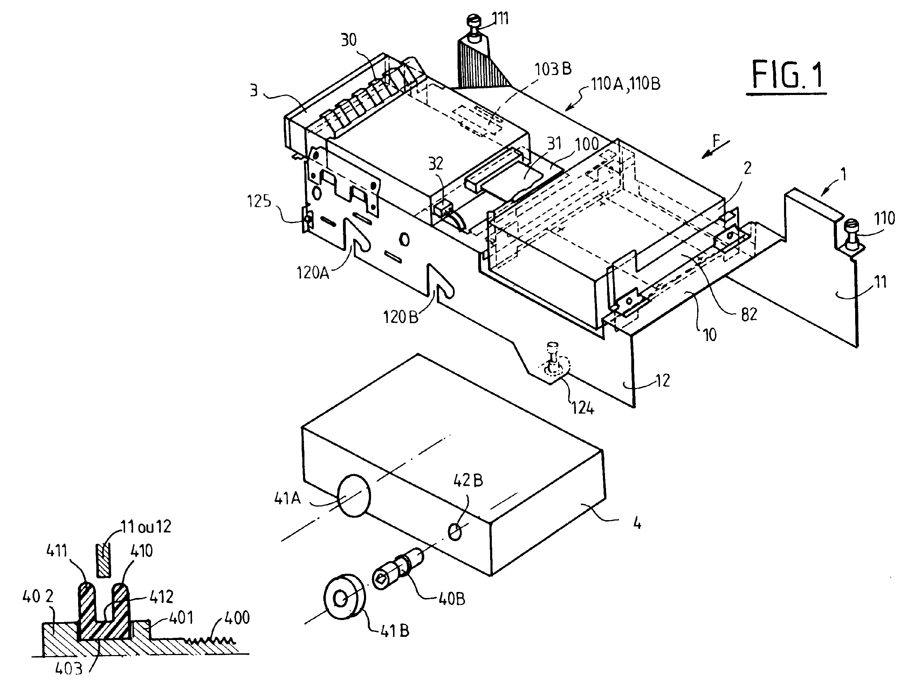

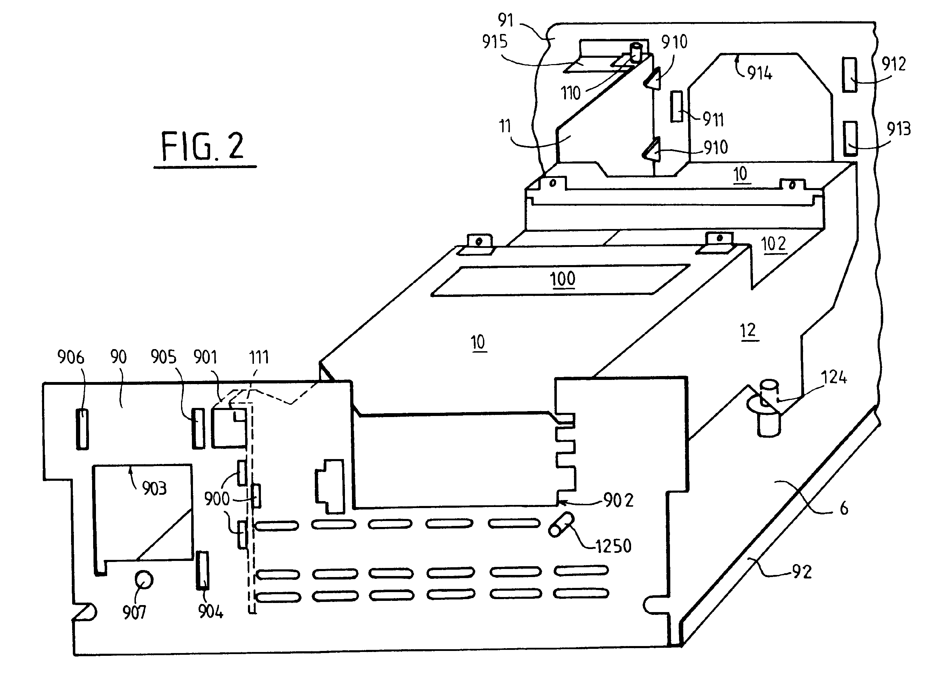

Le dispositif de fixation selon l'invention, représenté à la figure 1, permet de monter sur une pièce support (1), un premier périphérique d'ordinateur constitué par un lecteur de disquette (3), accessible par la face avant (90), figure 2, du châssis d'une machine constituée par un micro-ordinateur dans lequel le dispositif de fixation de périphériques est monté. Ce lecteur de disquette (3) constitue la configuration de base de la machine.

Ce dispositif de fixation de périphériques permet également de monter en option un lecteur de disque dur (2), selon une direction perpendiculaire à la direction du lecteur de disquettes, et à l'arrière de celui-ci pour permettre une utilisation optimale de l'espace disponible à l'arrière du lecteur de disquettes (3).

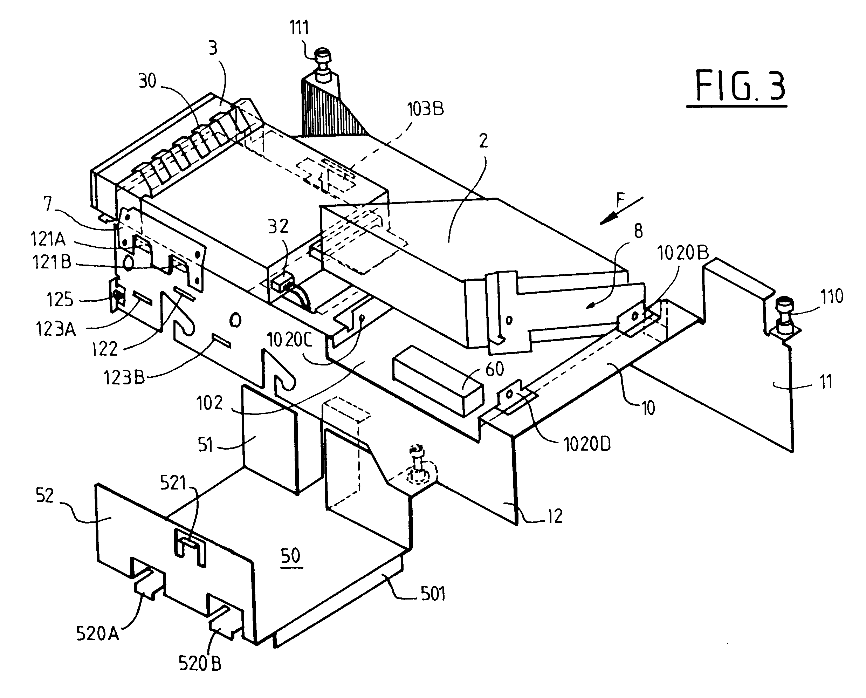

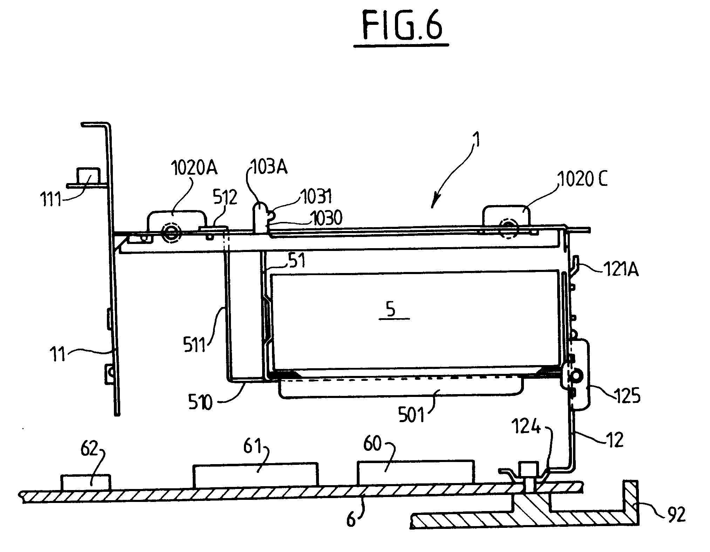

Comme représenté à la figure 3, ce lecteur de disque dur (2) est monté sur un berceau (8) pivotant autour de l'articulation (1020B, 1020A), de façon à permettre l'accès à des équipements électroniques, constitués par exemple par des connecteurs (60), disposés sur la carte de circuit imprimé (6, figure 6) sur laquelle vient se fixer la pièce support (1), à l'aide d'une vis et d'une patte (124) comportant un écrou.

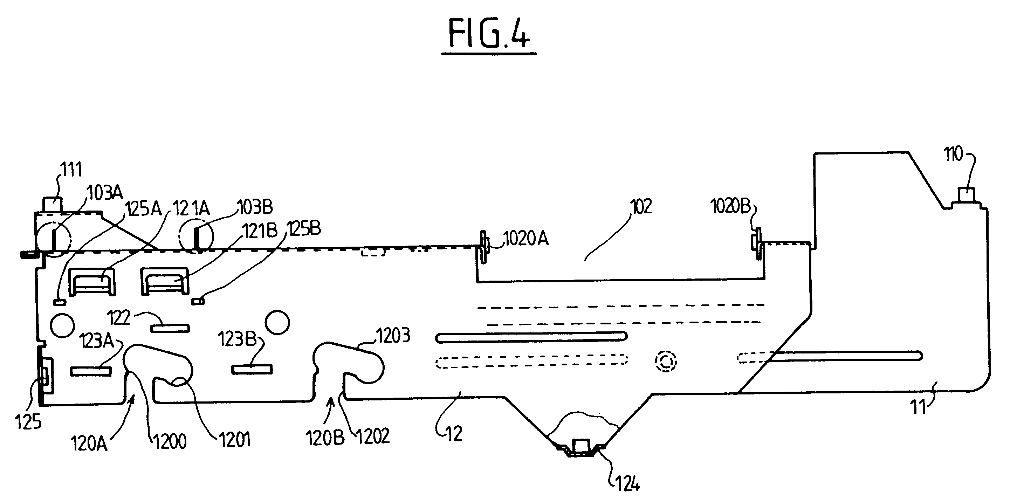

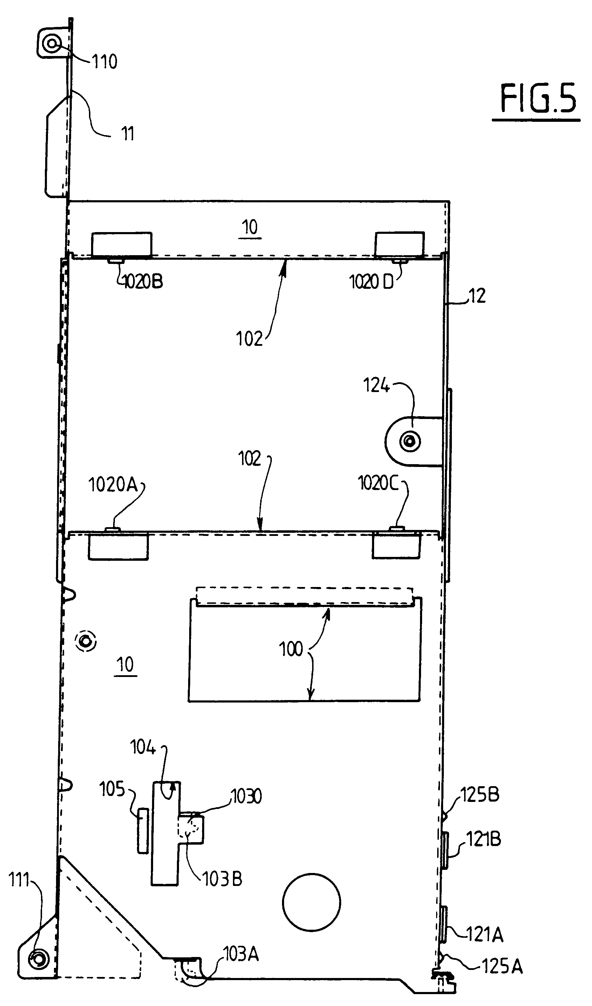

Comme représenté à la figure 3, le connecteur (60) est en vis-à-vis de l'ouverture (102) pratiquée dans la surface supérieure (10) de la pièce support (1). La pièce support (1), comme représenté aux figures 4 et 5, comporte une première surface (10) pourvue d'une ouverture (102) destinée à recevoir le moyen de fixation (8) du disque dur (2), et d'une ouverture (100) destinée à permettre le passage des nappes de fils reliant, par les connecteurs (31, 32), figures 1 et 3, le lecteur de disquettes (3) au circuit électronique figurant sur la carte (6). La pièce support (1) comporte également une deuxième surface (12) perpendiculaire à la première surface et orientée vers le bas de façon à former, avec une troisième surface (11), une pièce dont la section est substantiellement en forme de U.

Les deuxième et troisième surfaces, respectivement (12, 11), de la pièce support (1) comportent sur chaque surface, (12) respectivement (11), une paire de découpes (120A, 120B), respectivement (110A, 110B, figure 1), constituées chacune par une découpe verticale (1202), se prolongeant latéralement par une rampe inclinée (1203) pour finir par un point de fixation constitué par un bossage (1201).

La découpe verticale (1202) comporte également sur un de ses côtés un bossage (1200) permettant de constituer un point dur évitant un passage trop facile de la partie inclinée à la partie verticale. La portion inclinée (1203) est inclinée vers le bas selon un angle inférieur à 90° par rapport à la partie verticale. Ces paires de découpes pratiquées dans les surfaces latérales (11, 12) de la pièce de fixation (1) permettent, comme représenté à la figure 1, le montage d'un élément périphérique optionnel, constitué par exemple par un lecteur de disquette 5 ¼ pouces, ou un dérouleur de bandes rapide à cassette (4). Le boîtier du périphérique (4) est pourvu, sur chacune de ses faces latérales longitudinales (42) de deux trous taraudés (42A, 42B, 42C, 42D). Chacun des trous taraudés reçoit le filetage correspondant (40A, 40B, 40C, 40D) d'une vis dont la tête, par exemple à six pans creux, permet la fixation sur le corps du boîtier (4). Cette vis, représentée de façon agrandie dans la bulle de la figure 1, comporte en plus de son filtage (400) un épaulement (401) constituant, avec la tête (402), une gorge (403) dans laquelle vient se loger une rondelle passe-fils (41). A chaque vis (40A, 40B, 40C, 40D) est associée une rondelle passe-fils (41A, 41B, 41C, 41D) en matériau élastique. La rondelle passe-fils (41) comporte un disque (411) séparé d'un deuxième disque (410) par une gorge correspondant à l'épaisseur des deuxième et troisième surfaces latérales (12 ou 11) de la pièce support (1). Les deux disques (411, 410) sont reliés entre eux par une partie centrale de jonction (412). L'ensemble constitué par chaque rondelle passe-fils, chaque vis et chaque découpe (120) forme un élément de suspension et de fixation du boîtier de périphérique avec un moyen d'amortissement constitué par la rondelle passe-fils en matériau élastique.

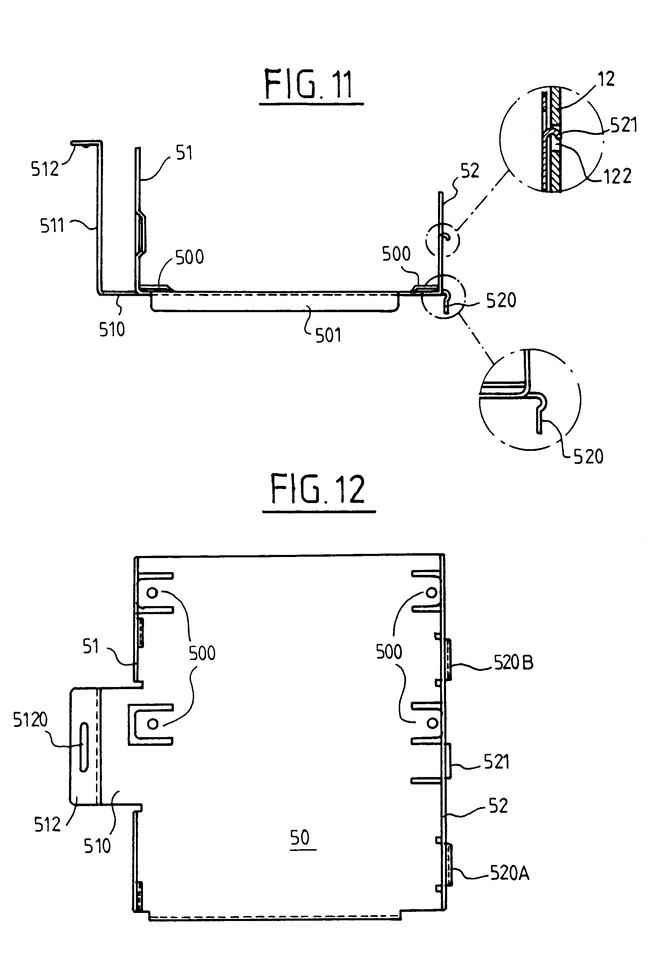

La figure 3 représente une variante dans laquelle, à la place d'un périphérique de dimension correspondant au module de 5 ¼ pouces, on monte un périphérique de dimension inférieure, correspondant aux normes de périphérique dite de 3 ½ pouces entre les surfaces latérales (12, 11) de la pièce de fixation (1). Pour ce faire, on utilise un deuxième moyen de fixation (50, 51, 52) du périphérique (5, représenté figure 6) constitué par un étrier comportant une partie centrale (50), des jambes latérales (52, 51) formant substantiellement une pièce dont la section est en U. La partie horizontale (50) se prolonge en avant et en arrière par une languette (501) rabattue selon un plan perpendiculaire, de façon à constituer un renfort de rigidité de cette surface. De même, cette surface (50) comporte des bossages (500, figure 12) permettant de mettre en appui sur ce bossage, comme représenté à la figure 6, le périphérique (5) et de maintenir ce périphérique par des vis qui passent dans les trous prévus sur ces bossages (500) pour se visser dans l'autre partie filetée du boîtier (5).

L'ensemble boîtier (5) moyens de fixation (50, 51, 52) est monté par pivotement en venant accrocher les languettes (520A, 520B), figures 3 et 12, dans les découpes (123A, 123B) prévues sur la deuxième surface (12, figure 4). Par pivotement, on amène la surface (52) au contact de la surface (12), ce qui permet à la languette (521), représenté à la figure 11, de pénétrer dans la découpe (122) de la surface (12, figures 3, 4 et 11), pour venir en appui contre la partie supérieure de cette découpe (122), alors que les languettes (520) sont en appui sur les parties inférieures des découpes (123). Dans le même temps, la languette (510) prolongeant la surface horizontale (50) comporte une portion (511) perpendiculaire à cette languette (510), et se termine par une partie horizontale (512) pourvu d'un bossage (5120), vient par déformation élastique faire passer cette partie horizontale (512) à travers une découpe (104) prévue sur la première surface (10) et de façon à positionner le bossage (5120) en vis-à-vis de la découpe (105) pour constituer ainsi un frein au retrait de la languette (512). La longueur de la partie (511) et des jambes (51) constituant l'étrier de section en forme de U, constitué par les surfaces (51, 50, 52), est calculée de façon à ce que lorsque la languette (512) est en appui sur la face supérieure de la première surface (10), l'extrémité des jambes (51) du U de suspension du boîtier de périphérique (5) est en appui sur la face inférieure de la surface (10), comme représenté à la figure 6.

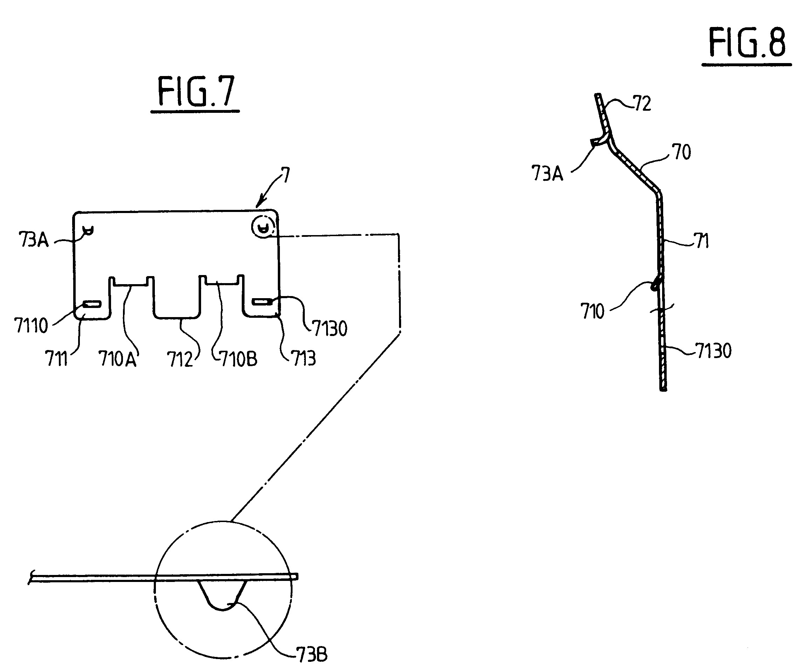

Le mode de fixation avantageux du premier périphérique constituant la configuration de base de la machine est formé d'une paire d'ergots (103A, 103B) (figure 4). Chaque ergot est constitué d'un téton (1030) découpé dans la surface (10), comme représenté en pointillé à la figure 5, et rabattu perpendiculairement à cette surface, comme représenté aux figures 4 et 6. Ce téton (1030) comporte, à une distance correspondant à l'emplacement des trous de fixation du périphérique et orienté selon l'axe de symétrie du second périphérique, c'est-à-dire perpendiculairement à l'axe de symétrie du premier périphérique, un ergot (1031). A cette paire d'ergots (103A, 103B) rigide et fixe, est associée une deuxième paire d'ergots (73A, 73B) montée sur une lame élastique (7), représentée à la figure 7. Cette lame élastique (7) comporte une partie inclinée (1070) qui lui donne son élasticité et une partie plane (71) qui permet sa fixation sur la surface latérale (12). Cette fixation est effectuée au moyen des languettes (121A, 121B), découpées dans la surface (12), comme représenté au figures 4 et 5. Ces languettes (121A, 121B), légèrement en saillie par rapport à la surface (12), permettent de glisser entre cette surface et la surface intérieure des languettes, les découpes (710A, 710B) pratiquées dans la lame élastique (7). Ces découpes (710A, 710B) comportent, comme représenté à la figure 8, une légère dépouille (710) facilitant l'introduction dans les languettes. Les découpes (710A, 710B) matérialisent dans la lame élastique trois jambes (711, 712, 713) dont les deux jambes externes (711, 713) sont pourvues respectivement d'une ouverture (7110, 7130) qui permet de recevoir des bossages (125A, 125B) formés sur la surface (12) pour éviter les déplacements vers le haut de la lame élastique (7) une fois celle-ci mise en place sur la surface (12). La pièce support (1), ainsi pourvue de la lame élastique (7), permet une mise en place d'un lecteur de disquettes (3), en introduisant premièrement les trous de fixation dans les ergots (1031A, 1031B) de la pièce support (1), et ensuite en faisant basculer par pivotement le boîtier, tout en écartant la lame élastique pour ensuite laisser les ergots de la lame élastique revenir se loger dans les trous de fixation situés sur la face du boîtier en vis-à-vis.

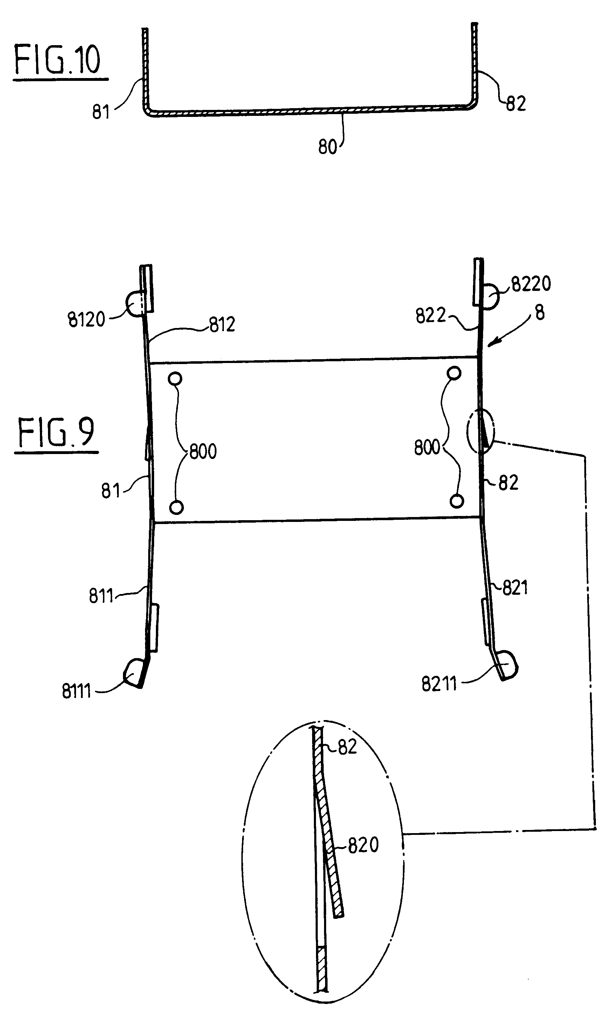

La fixation du disque dur (2) est assurée par un étrier (8), à section principale en forme de U, comme représenté aux figures 9 et 10. Les jambes latérales (81, 82) de cet étrier se prolongent en avant et en arrière par des bras latéraux (811, 812, 821, 822). Chacun des bras se prolonge vers l'extérieur par une languette (8120, 8111, 8211, 8220) de direction perpendiculaire aux jambes (81, 82) et parallèle au plan horizontal (80) sur lequel le périphérique est fixé. Le plan horizontal (80) comporte une série de quatre trous (800) permettant de fixer le périphérique sur la pièce de liaison. Les bras avant et arrière (811, 812, 821, 822) forment un léger angle avec les prolongements des surfaces latérales (81, 82). Ce léger angle permet de donner un débattement au bras élastique du dispositif de fixation. Ce débattement permet l'introduction des languettes (8120, 8220) dans les trous respectifs (1020A, 1020B), figures 4 et 3. Les trous (1020A, 1020B, 1020C, 1020D) sont pratiqués dans des découpes de la surface (10), après avoir replié une partie de celle-ci de façon à avoir l'axe de symétrie des traces (1020A, 1020B) parallèles aux surfaces (10, 11, 12) pour former un renfort de la surface (10). De même à une distance correspondant à la distance séparant les languettes (8120, 8220) des languettes (8111, 8211), on retrouve sur la pièce support (1) des trous correspondant (1020C, 1020D) dans lesquels les languettes (8111, 8211) peuvent pénétrer après déformation des bras élastiques (811, 821). Le montage du périphérique (2) s'effectue d'abord en réalisant sa fixation sur la pièce de liaison (8). Les bras arrière (812, 822) sont ensuite introduits de façon que les languettes (8120, 8220) pénètrent dans les orifices (1020A, 1020B), en déformant légèrement ces bras vers l'intérieur. Ensuite, le basculement du boîtier amène progressivement les languettes avant (8111, 8211) en vis-à-vis des orifices (1020C) et (1020D), en déformant les bras (811, 821) vers l'intérieur. Après relachement des bras (811, 821), les languettes pénètrent dans les orifices et solidarisent l'ensemble. Pour accéder au connecteur (60), il suffira, en appuyant sur les bras (811, 821) de dégager les languettes des trous correspondant, et permettre ainsi le basculement du périphérique.

La pièce support (1), équipée d'un ou plusieurs périphériques selon la configuration souhaitée, et correspondant dans une variante de configuration maximale à l'équipement représenté à la figure 1, ou dans une autre variante de configuration maximale à l'équipement représenté à la figure 3, est ensuite introduite dans le châssis de la machine constitué d'une plaque avant (90, figure 2), d'une plaque arrière (91) rendues solidaires d'une tôle de fond (92), sur laquelle repose une carte de circuit imprimé (6). La pièce de support (1) est glissée de façon à ce que son côté latéral (11) soit guidé et maintenu par des bossages (900) pratiqués sur la plaque avant (90) du châssis et des bossages (910) pratiqués sur la plaque arrière (91) du châssis. Ces bossages (900, 910) sont disposés de part et d'autre de l'emplacement dans lequel doit être maintenu la surface latérale (11). Des languettes découpées (901) sur la plaque avant (90) et (915) sur la plaque arrière (91) et rabattues perpendiculairement à ces plaques (90, 91), permettent de solidariser la pièce support avec les prolongements de la surface (11) constitués par les éléments de fixation (111) et (110) situés respectivement à l'avant et à l'arrière de la pièce support (1), figure 3. De même, un écrou avant solidaire par une languette (125) de la surface (12) permet de lier cette surface (12) à la face avant (90) par une vis (1250) représentée à la figure 2. Enfin, la patte (124) permet de fixer une vis destinée à rendre solidaire la surface (12) du circuit imprimé (6) et de la face inférieur du châssis (92), comme représenté à la figure 6.

On comprend, à la lecture de la description ci-dessus que l'on a ainsi réalisé un dispositif de fixation de périphérique permettant d'équiper, de façon simple et économique, une machine, à la demande du client, d'options différentes au point de vue périphériques. De plus, la simplicité de montage des différents périphériques permet une automatisation et un accès facile aux pièces principales de la machine pour les opérations de maintenance.

Toutes modifications à la portée de l'homme de métier font également partie de l'esprit de l'invention telle que definie par les revendications.

## Revendications

1. Dispositif de fixation pour périphérique d'ordinateur, comprenant une pièce support (1), montée solidaire de façon amovible à un châssis (90, 91, 92) d'un micro-ordinateur, la pièce support comprenant une première (10) une seconde (12) et une troisième surface (11), les dites seconde et troisième surfaces (12,11) étant d'une part mutuellement parallèles et d'autre part perpendiculaires à la première surface (10) formant ainsi une pièce en U avec des jambes orientées vers le bas, ladite première surface (10) comprenant des premiers moyens de fixation pour fixer un premier périphérique (3) à ladite pièce support sur un côté de ladite première surface (10) opposé aux jambes s'étendant vers le bas, et dans lequel un premier jeu d'ergots (103) est disposé sur ladite première surface (10) et une lame élastique (7) est disposée perpendiculairement à ladite première surface (10) et parallèle au dit premier jeu d'ergots (103), ladite lame étant fixée à une des dites seconde (12) et troisième (11) surfaces perpendiculaires à la première surface (10), ladite lame élastique (7) ayant un second jeu d'ergots (73) formé dans cette lame, ledit second jeu d'ergots (73) est espacé du premier jeu d'ergots (103) d'une distance correspondant à l'espacement des trous de fixation du boîtier du premier périphérique (3) et dans lequel chaque ergot du second jeu pénètre une ouverture de fixation correspondante quand le dit périphérique est monté sur le dispositif.

2. Dispositif de fixation selon la revendication 1, caractérisé en ce que la lame élastique (7) est fixée de façon amovible sur la seconde surface (12), la seconde surface étant perpendiculaire à, et intégrée à ladite première surface (10) et disposée dans une direction opposée au premier jeu d'ergots (103), la lame (7) ayant deux découpes (710A, 710B) et deux ouvertures (7110, 7130) ladite seconde surface ayant deux languettes (121A, 121B) et deux bossages (125A, 125B) formés par emboutissage et déformation de ladite seconde surface (12), les découpes (710A,710B) étant adaptées pour être placées sous les deux langues (121A, 121B) de la seconde surface (12), les bossages (125A, 125B) étant disposés pour se clipser dans les ouvertures correspondantes (7110, 7130) de la lame élastique.

3. Dispositif de fixation selon la revendication 1, caractérisé en ce que ladite pièce support (1) est adaptée pour recevoir un second moyen pour monter de façon amovible un second périphérique (4) ledit second moyen de fixation étant monté entre les jambes de la pièce support (1) en forme de U.

4. Dispositif de fixation selon la revendication 3, caractérisé en ce que le second moyen de fixation pour monter un second périphérique (4), comprend une paire de découpes (102A, 102B, 110A, 110B) embouties disposées dans chacune des seconde (12) et troisième (11) surfaces, chacune des découpes comprenant une portion de découpe verticale et une portion inclinée en rampe s'étendant latéralement, ladite portion de rampe inclinée se terminant avec un point de blocage (1201) pour accueillir des passe-fils (41A,41B,41C,41D) en matériau élastique et amortisseur montés sur des vis (40A,40B,40C,40D) de fixation visées sur les trous de fixation (42A,42B,42C,42D) d'un boîtier du second périphérique (4).

5. Dispositif de fixation selon la revendication 3, caractérisé en ce que les seconds moyens de fixation pour fixer un second périphérique (4) comprennent par un étrier en U (50, 51, 52) ayant une surface (50) qui est disposée horizontalement quand les dits seconds moyens de fixation sont montés sur la pièce support (1) et ayant deux jambes orientées verticalement vers le haut, ledit étrier étant monté de façon amovible à l'aide d'un assemblage à charnières (520, 123) et suspendu à la première surface (10) par une languette élastique (510, 511) adjacente à la première jambe comportant une languette d'accrochage (512) destinée, après être passée à travers une ouverture (104) de la première surface (10), à appuyer contre la face supérieure de la première surface (10), la première jambe (51) du U venant en appui contre la face inférieure de ladite première surface (10) à proximité de la languette d'accrochage (512).

6. Dispositif de fixation selon la revendication 5, caractérisé en ce que l'articulation charnière (123, 520), est intégrée à la seconde jambe (52) du U, et comporte des moyens pour positionner la surface horizontale (50) de l'étrier une fois que la langue (512) est verrouillée, les moyens étant constitués par un rebord plié (521) venant appuyer sur la partie supérieure d'une découpe (122) prévue à cet effet dans la deuxième surface (12), tandis que les languettes (520A, 520B) formant l'articulation appuient sur la partie inférieure des découpes (123A, 123B) prévues dans la deuxième surface (12).

7. Dispositif de fixation selon une des revendications 1 à 6, caractérisé en ce que le dispositif comprend des troisièmes moyens pour monter un troisième périphérique et ledit dispositif comportant une ouverture (102) prévue dans la première surface (10), à l'arrière des premiers moyens pour le premier périphérique (3), l'ouverture (102) étant destinée à recevoir lesdits troisièmes moyens (8) de fixation du périphérique (2) montés selon une direction perpendiculaire à la direction du premier périphérique (3), les dits troisièmes moyens (8) permettant de basculer temporairement le périphérique pour accéder à un connecteur (60) situé sur une carte (6) de circuit imprimé sur laquelle est montée la pièce de support (1).

8. Dispositif de fixation selon la revendication 7 caractérisé en ce que le troisième moyen de fixation (8) comprend un étrier en forme de U (80, 81, 82) ayant deux jambes latérales (81,82) et une portion centrale (80), dont les jambes (81, 82) se prolongent en avant et en arrière de la partie centrale du U par des bras (812, 811, 821, 822), et disposée en vis à vis d'une première paire de bras (812, 822) des moyens (1020A,1020B) permettant l'articulation sur les côtés de l'ouverture (102), une seconde paire de bras (811, 821) comportant des moyens (8211, 8111) d'encliquetage sur les surfaces (1020C, 1020D) de l'ouverture prévue à cet effet pour constituer la position d'utilisation du périphérique (2), tandis que l'élasticité de cette seconde paire de bras (811, 821) permet leur dégagement par désencliquetage pour autoriser le basculement.

9. Utilisation du dispositif de fixation pour périphérique d'ordinateur selon une des revendications précédentes caractérisé en ce qu'un dispositif de fixation est monté dans un châssis d'ordinateur ayant un panneau de fond, une plaque avant (90) et une plaque arrière (91) par coulissement entre des rainures constituées par des bossages (900, 910) réalisés sur les plaques avant (90) et arrière (91) du châssis et solidarisé aux plaques et à une carte de circuit imprimé (6) reposant sur le fond (92)du châssis de l'ordinateur par des moyens de fixation démontables (111, 110, 124).

## Claims

1. A fastening device for computer peripherals, comprising a support part (1), mounted firmly, so as to be removable, on a frame (90, 91, 92) of a micro-computer, the support part comprising a first (10), a second (12) and a third (11) surface, said second and third surfaces (12, 11) being on the one hand mutually parallel and on the other hand perpendicular to the first surface (10) thus forming a U-shaped part with the legs pointing downwards, said first surface (10) comprising first fastening means for fastening a first peripheral (3) to said support part on one side of said first surface (10) opposite the legs extending downwards, and in which a first set of lugs (103) is arranged on said first surface (10) and a resilient blade (7) is disposed perpendicular to said first surface (10) and parallel to said first set of lugs (103), said blade being fixed to one of said second (12) and third (11) surfaces perpendicular to the first surface (10), said resilient blade (7) having a second set of lugs (73) formed in this blade, said second set of lugs (73) is set apart from the first set of lugs (103) by a distance corresponding to the spacing of the fastening holes of the housing of the first peripheral (3) and in which each lug of the second set penetrates into a corresponding fastening aperture when said peripheral is mounted on the device.

2. A fastening device according to Claim 1, characterised in that the resilient blade (7) is fastened, so as to be removable, to the second surface (12), the second surface being perpendicular to, and integrated with said first surface (10) and arranged in the opposite direction to the first set of lugs (103), the blade (7) having two cut-outs (710A, 710B) and two apertures (7110, 7130), said second surface having two small tongues (121A, 121B) and two bosses (125A, 125B) formed by the stamping and deformation of said second surface (12), the cut-outs (710A, 710B) being suitable for being placed under the two tongues (121A, 121B) of the second surface (12), the bosses (125A, 125B) being arranged so as to clip into the corresponding apertures (7110, 7130) of the resilient blade.

3. A fastening device according to Claim 1, characterised in that said support part (1) is suitable for receiving a second means for mounting a second peripheral (4) so as to be removable, said second fastening means being mounted between the legs of the U-shaped support part (1).

4. A fastening device according to Claim 3, characterised in that the second fastening means for mounting a second peripheral (4) comprises a pair of stamped cut-outs (102A, 102B, 110A, 110B) arranged in each of the second (12) and third (11) surfaces, each of the cut-outs comprising a vertical cut-out portion and a portion sloping like a ramp extending laterally, said sloping ramp portion ending in a locking point (1201) to receive grommets (41A, 41B, 41C, 41D) made of a resilient and damping material mounted on fastening screws (40A, 40B, 40C, 40D) aimed at the fastening holes (42A, 42B, 42C, 42D) of a housing of the second peripheral (4).

5. A fastening device according to Claim 3, characterised in that the second fastening means for fastening a second peripheral (4) comprise a U-shaped stirrup (50, 51, 52) having a surface (50) which is arranged horizontally when said second fastening means are mounted on the support part (1) and having two legs pointing vertically upwards, said stirrup being mounted, so as to be removable, with the aid of a hinged assembly (520, 123) and suspended from the first surface (10) by a small resilient tongue (510, 511) adjacent to the first leg comprising a small hooking tongue (512) intended, after being passed through an aperture (104) of the first surface (10), to abut the upper face of the first surface (10), the first leg (51) of the U coming to rest against the lower face of said first surface (10) near the small hooking tongue (512).

6. A fastening device according to Claim 5, characterised in that the hinge joint (123, 520) is integrated with the second leg (52) of the U, and comprises means for positioning the horizontal surface (50) of the stirrup once the tongue (512) is locked, the means being constituted of a folded edge (521) coming to rest on the upper portion of a cut-out (122) provided for this purpose in the second surface (12), while the small tongues (520A, 520B) forming the hinge abut the lower portion of the cut-outs (123A, 123B) provided in the second surface (12).

7. A fastening device according to one of Claims 1 to 6, characterised in that the device comprises third means for mounting a third peripheral and said device comprising an aperture (102) provided in the first surface (10), behind the first means for the first peripheral (3), the opening (102) being intended to receive said third means (8) for fastening the peripheral (2) mounted in a direction perpendicular to the direction of the first peripheral (3), said third means (8) allowing the peripheral to tilt temporarily so as to gain access to a connector (60) located on a printed circuit board (6) on which the support part is mounted (1).

8. A fastening device according to Claim 7, characterised in that the third fastening means (8) comprises a U-shaped stirrup (80, 81, 82) having two lateral legs (81, 82) and a central portion (80), the legs (81, 82) of which are extended in front of and behind the central part of the U by arms (812, 811, 821, 822) and, arranged on the opposite side of a first pair of arms (812, 822), means (1020A, 1020B) allowing hinging to the sides of the aperture (102), a second pair of arms (811, 821) comprising means (8211, 8111) for clicking to the surfaces (1020C, 1020D) of the aperture provided for this purpose in order to constitute the position of use of the peripheral (2), while the elasticity of this second pair of arms (811, 821) allows them to be disengaged by clicking out, in order to permit tilting.

9. Use of the fastening device for a computer periperal according to one of the preceding claims, characterised in that a fastening device is mounted in a computer frame having a bottom panel, a front plate (90) and a rear plate (91) by sliding between grooves constituted of bosses (900, 910) made on the front (90) and rear (91) plates of the frame and made integral with the plates and a printed circuit board (6) resting on the bottom (92) of the computer frame by demountable fastening means (111, 110, 124).

## Patentansprüche

1. Befestigungseinrichtung für Computer-Peripheriegerät, mit einem Trageteil (1), das an einem Rahmen (90, 91, 92) eines Mikrocomputers auf abnehmbare Weise fest angebracht ist, wobei das Trageteil eine erste (10), eine zweite (12) und eine dritte Fläche (11) aufweist, wobei die zweite und die dritte Fläche (12, 11) einerseits zueinander parallel und andererseits zur ersten Fläche (10) senkrecht sind und somit ein U-Teil mit nach unten gerichteten Schenkeln bilden, wobei die erste Fläche (10) erste Befestigungsmittel aufweist, um ein erstes Peripheriegerät (3) am Trageteil an einer Seite der genannten ersten Fläche (10) zu befestigen, welche den nach unten sich erstreckenden Schenkeln entgegengesetzt ist, wobei in der Befestigungseinrichtung an der ersten Fläche (10) eine erste Gruppe von Vorsprüngen (103) angeordnet ist und senkrecht zur ersten Fläche (10) und parallel zur ersten Gruppe von Vorsprüngen (103) ein elastisches Plättchen (7) angeordnet ist, wobei das Plättchen entweder an der zweiten (12) oder an der dritten (11) Fläche befestigt ist, die zur ersten Fläche (10) senkrecht sind, wobei das elastische Plättchen (7) eine zweite Gruppe von Vorsprüngen (73) besitzt, die in diesem Plättchen gebildet sind, wobei die zweite Gruppe von Vorsprüngen (73) von der ersten Gruppe von Vorsprüngen (103) um eine Strecke entfernt ist, die dem Zwischenraum von Befestigungslöchern des Gehäuses des ersten Peripheriegeräts (3) entsprechen, und wobei in der Befestigungseinrichtung jeder Vorsprung der zweiten Gruppe in eine entsprechende Befestigungsöffnung eindringt, wenn das genannte Peripheriegerät an der Einrichtung angebracht wird.

2. Befestigungseinrichtung gemäß Anspruch 1, dadurch gekennzeichnet, daß das elastische Plättchen (7) auf ablösbare Weise an der zweiten Fläche (12) befestigt ist, wobei die zweite Fläche zur ersten Fläche (10) senkrecht und mit dieser einteilig ausgebildet und in einer Richtung angeordnet ist, die zur ersten Gruppe von Vorsprüngen (103) entgegengesetzt ist, wobei das Plättchen (7) zwei Ausschnitte (710A, 710B) und zwei Öffnungen (7110, 7130) besitzt, wobei die zweite Fläche zwei Laschen (121A, 121B) und zwei Höcker (125A, 125B) besitzt, die durch einen Ziehvorgang und durch Verformen der zweiten Fläche (12) gebildet sind, wobei die Ausschnitte (710A, 710B) so beschaffen sind, daß sie unter den beiden Zungen (121A, 121B) der zweiten Fläche (12) angeordnet werden, wobei die Höcker (125A, 125B) so angeordnet sind, daß sie in die entsprechenden Öffnungen (7110, 7130) des elastischen Plättchens einrasten.

3. Befestigungseinrichtung gemäß Anspruch 1, dadurch gekennzeichnet, daß das Trageteil (1) so beschaffen ist, daß es ein zweites Mittel für die lösbare Anbringung eines zweiten Peripheriegeräts (4) aufnehmen kann, wobei das zweite Befestigungsmittel zwischen den Schenkeln des U-förmigen Trageteils (1) angebracht ist.

4. Befestigungseinrichtung gemäß Anspruch 3, dadurch gekennzeichnet, daß das zweite Befestigungsmittel für die Anbringung eines zweiten Peripheriegeräts (4) ein Paar von gezogenen Ausschnitten (102A, 102B, 110A, 110B) umfaßt, die in der zweiten (12) und in der dritten (11) Fläche angeordnet sind, wobei jeder Ausschnitt einen vertikalen Ausschnittbereich und einen seitlich sich erstreckenden, schrägen Rampenbereich aufweist, wobei der schräge Rampenbereich in einem Verriegelungspunkt (1201) endet, um Drahtdurchführungen (41A, 41B, 41C, 41D) aus elastischem und dämpfenden Material aufzunehmen, die an Befestigungsschrauben (40A, 40B, 40C, 40D) angebracht sind, die in die Befestigungsbohrungen (42A, 42B, 42C, 42D) eines Gehäuses des zweiten Peripheriegerätes (4) eingeschraubt sind.

5. Befestigungseinrichtung gemäß Anspruch 3, dadurch gekennzeichnet, daß die zweiten Befestigungsmittel für die Befestigung eines zweiten Peripheriegerätes (4) einen U-Bügel (50, 51, 52) aufweisen, der eine Fläche (50), die horizontal angeordnet ist, wenn die zweiten Befestigungsmittel am Trageteil (1) angebracht sind, sowie zwei vertikal nach oben gerichtete Schenkel besitzt, wobei der Bügel auf ablösbare Weise mit Hilfe einer Scharnierverbindung (520, 123) angebracht ist und an der ersten Fläche (10) mittels einer elastischen Lasche (510, 511) aufgehängt ist, die an den ersten Schenkel angrenzt und eine Einhaklasche (512) aufweist, die dazu bestimmt ist, sich nach dem Durchführen durch eine Öffnung (104) der ersten Fläche (10) gegen die obere Fläche der ersten Fläche (10) abzustützen, wobei sich der erste Schenkel (51) des U's an der unteren Fläche der ersten Fläche (10) in der Nähe der Einhaklasche (512) abstützt.

6. Befestigungseinrichtung gemäß Anspruch 5, dadurch gekennzeichnet, daß das Scharniergelenk (123, 520) mit dem zweiten Schenkel (52) des U's einteilig ausgebildet ist und Mittel aufweist, um die horizontale Fläche (50) des Bügels zu positionieren, sobald die Zunge (512) verriegelt ist, wobei die Mittel durch eine umgeknickte Kante (521) gebildet sind, die sich am oberen Teil eines Ausschnitts (122) abstützen, der hierzu in der zweiten Fläche (12) vorgesehen ist, während die Laschen (520A, 520B), die das Gelenk bilden, sich am unteren Teil der Ausschnitte (123A, 123B) abstützen, die in der zweiten Fläche (12) vorgesehen sind.

7. Befestigungseinrichtung gemäß einem der Ansprüche 1 bis 6, dadurch gekennzeichnet, daß die Einrichtung dritte Mittel aufweist, um ein drittes Peripheriegerät anzubringen, und die Einrichtung eine Öffnung (102) aufweist, die in der ersten Fläche (10) hinter den ersten Mitteln für das erste Peripheriegerät (3) vorgesehen ist, wobei die Öffnung (102) dazu bestimmt ist, die dritten Mittel (8) für die Befestigung des Peripheriegeräts (2), die in einer zur Richtung des ersten Peripherigeräts (3) senkrechten Richtung angebracht sind, aufzunehmen, wobei die dritten Mittel (8) ein vorübergehendes Kippen des Peripheriegeräts gestatten, um auf einen Verbindungsanschluß (60) zuzugreifen, der sich auf einer gedruckten Schaltungskarte (6) befindet, auf der das Trageteil (1) angebracht ist.

8. Befestigungseinrichtung gemäß Anspruch 7, dadurch gekennzeichnet, daß das dritte Befestigungsmittel (8) einen U-Bügel (80, 81, 82) aufweist, der zwei Seitenschenkel (81, 82) und einen Mittelbereich (80) besitzt, wobei die Schenkel (81, 82) über den mittleren Teil des U's nach vorne und nach hinten durch Arme (812, 811, 821, 822) verlängert sind, wobei gegenüber einem ersten Paar von Armen (812, 822) Mittel (1020A, 1020B) angeordnet sind, die eine Anlenkung an den Seiten der Öffnung (102) gestatten, wobei ein zweites Paar von Armen (811, 821) Mittel (8211, 8111) zum Einrasten an den Flächen (1020C, 1020D) der hierzu vorgesehenen Öffnung aufweist, um die Betriebsposition des Peripherigerätes (2) zu bilden, während die Elastizität dieses zweiten Paars von Armen (811, 821) deren Ablösung durch Ausrasten gestattet, um das Kippen zuzulassen.

9. Anwendung der Befestigungseinrichtung für Computer-Peripheriegerät gemäß einem der vorangehenden Ansprüche, dadurch gekennzeichnet, daß eine Befestigungseinrichtung in einem Computerrahmen mit einer Bodenplatte, einer vorderen Platte (90) und einer hinteren Platte (91) durch Gleiten zwischen Rillen angebracht wird, die durch Höcker (900, 910) gebildet sind, die in der vorderen Platte (90) und in der hinteren Platte (91) des Rahmens verwirklicht sind, und mit den Platten sowie mit einer auf dem Boden (92) des Rahmens aufruhenden gedruckten Schaltungskarte (6) durch abnehmbare Befestigungsmittel (111, 110, 124) verbunden ist.
